# EUROPÄISCHE PATENTANMELDUNG

(11) **EP 0 789 394 A2**
(43) Veröffentlichungstag der Anmeldung: **13.08.1997**
(21) Anmeldenummer: 97101703.3
(22) Anmeldetag: 04.02.1997
(51) Int. Cl.: H01L 21/78

(54) **Verfahren zum Vereinzeln von in einem Körper enthaltenen elektronischen Elementen**

(30) Priorität: 07.02.1996 DE 19604405
(71) Anmelder: Deutsche ITT Industries GmbH, 79108 Freiburg (DE)
(72) Erfinder: Igel, Günter, Dipl.-Ing., 79331 Teningen (DE); Mall, Martin, Dr. Dipl.-Phys., 79100 Freiburg (DE)

(57) **Zusammenfassung**

Die Erfindung betrifft ein Verfahren zum Vereinzeln von in einem Körper enthaltenen elektronischen Elementen, welche an der Oberfläche des Körpers vorgesehen und mit einer Schutzschicht 5 überdeckt sind. In der Schutzschicht 5 sind über Trennbereichen 6 zwischen benachbarten elektronischen Elementen 4 Öffnungen 7 vorgesehen. Das Material des Körpers wird in den Trennbereichen 6 von den Öffnungen 7 ausgehend abgetragen und die elektronischen Elemente 4 sind in dem Körper zumindest während des Abtragvorgangs durch einen Bereich mit einer von dem Material des Körpers verschiedenen Abtrageigenschaft begrenzt.

## Beschreibung

Die Erfindung betrifft ein Verfahren zum Vereinzeln von in einem Körper enthaltenen elektronischen Elementen, welche an einer Oberfläche des Körpers vorgesehen und mit einer Schutzschicht überdeckt sind.

Als elektronische Elemente kommen beispielsweise in einem Halbleiterwafer ausgebildete elektronische Elemente, insbesondere IC (integrierte Schaltungs)-Elemente, Diskrete Elemente, Sensorelemente, Displayelemente, Widerstände oder Leiterbahnen auf Al-Oxid und ähnliches in Betracht. In der Praxis erfolgt das Vereinzeln solcher elektronischen Elemente meist dadurch, daß der Körper abgedünnt und die elektronischen Elemente durch Sägen voneinander getrennt werden. Ein derartiges Verfahren hat den Nachteil, daß in dem Körper aufgrund der mechanischen Beanspruchung Risse entstehen und somit auch die elektronischen Elemente beschädigt werden können. Somit ist ein derartiges Verfahren relativ aufwendig und teuer.

Zudem muß der Körper ausreichend dick sein, um beim Bearbeiten eine genügende mechanische Stabilität aufzuweisen. Dies ist insbesondere in der Halbleitertechnologie problematisch, da dort Halbleiterwafer mit größerem Durchmesser wünschenswert sind, die zur Bearbeitung dann auch eine entsprechende größere Dicke aufweisen müssen. Dies hat zur Folge, daß ein erheblicher Anteil des Wafermaterials nur für die mechanische Stabilität, aber nicht für die Funktion der elektronischen Elemente benötigt wird.

Der Erfindung liegt die Aufgabe zugrunde, ein Verfahren zum Vereinzeln von in einem Körper enthaltenen elektronischen Elemente zu schaffen, welches einfacher und kostensparender ist.

Diese Aufgabe wird durch ein gattungsgemäßes Verfahren gelöst, bei dem in der Schutzschicht über Trennbereichen zwischen benachbarten elektronischen Elementen Öffnungen vorgesehen sind, bei dem das Material des Körpers in den Trennbereichen, von den Öffnungen ausgehend, abgetragen wird, und die elektronischen Elemente in dem Körper zumindest während des Abtragvorgangs durch einen Bereich mit einer von dem Material des Körpers verschiedenen Abtrageigenschaft begrenzt sind.

Die Abtrageigenschaft des die elektronischen Elemente umgebenden Bereiches kann dabei so gewählt sein, daß das Abtragen des Materials in diesem Bereich schneller oder langsamer erfolgt als das Abtragen des Materials des Körpers. Erfolgt das Abtragen in den Bereichen langsamer, so wird das Material des Körpers von den Öffnungen ausgehend, zwischen den zueinander benachbarten, die elektronischen Elemente umgebenden Bereiche schneller abgetragen, so daß die elektronischen Elemente mit einem Teil oder dem ganzen sie umgebenden Bereich aus dem Körper herausgelöst werden. Ist die Abtrageigenschaft so gewählt, daß der Abtragvorgang in dem die elektronischen Elemente umgebenden Bereichen schneller erfolgt als in dem Material des Körpers, so wird bei dem Abtragvorgang dieser Bereich am schnellsten entfernt, so daß die elektronischen Elemente gegebenenfalls mit einem Teil des Materials des Körpers, welches zwischen den elektronischen Elementen und dem Bereich liegt, herausgelöst werden.

Bei dem erfindungsgemäßen Verfahren können die elektronische Elemente auf einfache Weise von der Oberfläche des Körpers ausgehend aus diesem herausgelöst werden. Durch das Abtragen des Materials des Körpers auf diese Weise wird das Trennen der elekronischen Elemente voneinander und das Trennen der elektronischen Elemente von dem Körper gleichzeitig erreicht. Ein Abdünnen des Körpers ist dann nicht mehr erforderlich, so daß Prozeßaufwand und Material gespart werden können. Es wird durch dieses Verfahren auch ermöglicht, daß der verbleibende Körper wieder in die Form eines neuen Körpers gebracht werden kann, in welchem erneut elektronische Elemente ausgebildet werden können. Somit kann der Körper effektiv genutzt werden.

Dies ist insbesondere in der Halbleitergechnologie, in der das Material von Halbleiterwafern sehr teuer ist, vorteilhaft.

Das Verfahren ist dann besonders vorteilhaft, wenn die elektronischen Elemente bereits mit einer Schutzschicht überdeckt sind. Bei sehr vielen elektronischen Elementen wurde im vorherigen Herstellungsverfahren eine solche Schutzschicht bereits aufgebracht. Bei vielen Anordnungen können auch bereits die Öffnungen zwischen benachbarten elektronischen Elementen in der Schutzschicht vorhanden sein. In diesem Fall kann das Material des Körpers direkt von der Oberfläche des Körpers von den Öffnungen in der Schutzschicht ausgehend abgetragen werden, so daß die elektronischen Elemente aus dem Körper herausgelöst werden. Das erfindungsgemäße Verfahren ist dann besonders einfach und zeitsparend und daher auch kostengünstig. Es kann aber auch angewendet werden, wenn eine den gesamten Körper überdeckende Schutzschicht aufgebracht worden ist. Dann müssen durch einen weiteren Strukturierungsprozeß die Öffnungen zwischen den benachbarten elektronischen Elementen erzeugt werden. Auch kann die Schutzschicht als zusätzliche Schicht auf die Oberfläche des Körpers mit den elektronischen Elementen mit den Öffnungen aufgebracht werden, damit dann der Abtragvorgang von der Oberfläche aus geschehen kann.

Gemäß einem bevorzugten Anwendungsbeispiel des erfindungsgemäßen Verfahrens, sind die elektronischen Elemente auf der Vorderseite und auf der Rückseite des Körpers vorgesehen. In diesem Fall können die elektronischen Elemente beidseitig und gleichzeitig aus dem Körper herausgelöst werden. Es ist dabei nicht mehr erforderlich, zwei einander gegenüberliegende elektronische Elemente, die auf der Vorder- und der Rückseite des Körpers vorgesehen sind, einzeln voneinander zu trennen. Dies wäre dann erforderlich, wenn mit herkömmlichen Techniken zwei nebeneinanderliegende Elementpaare (von Vorder- und Rückseite des Körpers) voneinander getrennt würden. Ein derartiges Elementpaar voneinander zu trennen, ist aufwendig, da die einzelnen Elementpaare einzeln gehandhabt, justiert und bearbeitet werden müßten. Dies wäre auch in vielen Anwendungsbereichen, wie beispielsweise in der Halbleitertechnologie auch technisch nur sehr aufwendig durchführbar. Ferner können gemäß der Erfindung die elektronischen Elemente auf der Vorder- und Rückseite des Körpers völlig unabhängig voneinander vorgesehen werden, so daß beispielsweise auch voneinander verschiedene Elemente auf der Vorder- und auf der Rückseite vorgesehen werden können. Außerdem können die Elemente auf der Vorderseite im Vergleich zu den Elementen auf der Rückseite unterschiedliche Abmessungen aufweisen.

Gemäß einem günstigen Ausführungsbeipiel der Erfindung erfolgt das Abtragen des Materials des Körpers durch Ätzen. Dabei ist das Plasmaätzen besonders vorteilhaft, da dabei das Herauslösen der elektronischen Elemente in kurzer Zeit erfolgen kann. Abhängig von den sonstigen Bedingungen können aber auch andere Abtragsarten wie Naßätzen günstig sein. Vorteilhafterweise erfolgt das Abtragen des Materials des Körpers im wesentlichen isotrop. Dadurch wird sichergestellt, daß das Trennen der elektronischen Elemente von dem Körper in der Richtung parallel zu der Oberfläche des Körpers stark genug ist, und somit das Heraustrennen der elektronischen Elemente bereits in geringer Entfernung von der Oberfläche erfolgen kann.

Gemäß einem vorteilhaften Ausführungsbeispiel der Erfindung hat das Material der Schutzschicht eine wesentlich kleinere Ätzrate als das Material des Körpers. Dadurch wird sichergestellt, daß von der Schutzschicht beim Herauslösen der elektronischen Elemente aus dem Körper nur ein geringer Teil abgetragen wird, so daß ein genügend großer Teil der Schutzschicht vorhanden bleibt und bei der Anwendung der elektronischen Elemente zu deren Schutz verwendet werden kann.

Gemäß einem bevorzugten Ausführungsbeispiel der Erfindung wird der die elektronischen Elemente begrenzende Bereich durch eine elektrische Potentialdifferenz gebildet. Dies ist insbesondere beim Heraustrennen der elektronischen Elemente durch Naßätzen vorteilhaft, da dann durch Anlegen einer elektrischen Spannung ein Bereich mit einer von dem Material des Körpers verschiedenen Abtrageigenschaft aufgrund eines anderen elektrischen Potentials erzeugt werden kann. Bei diesem Verfahren ist keine materielle Einwirkung zur Erzeugung dieses Bereichs auf den Körper erforderlich. Durch die Wahl des aufgrund der elektrischen Potentialdiffernz erzeugten elektrischen Potentialgradienten kann bestimmt werden, ob das Abtragen des Materials in dem Bereich schneller oder langsamer erfolgt als in dem Material des Körpers. Die Potentialdifferenz kann beispielsweise auch durch einen pn-Übergang gebildet werden, welcher gegebenenfalls durch ein äußeres Potential verstärkt werden kann.

Gemäß einem anderen bevorzugten Ausführungsbeispiel der Erfindung ist der die elektronischen Elemente begrenzende Bereich eine Verzögerungsschicht, deren Ätzrate von der Ätzrate des Materials des Körpers verschieden ist. Der Körper kann dabei ein Siliziumwafer sein und die Verzögerungsschicht kann Silizium und wenigstens ein weiteres chemisches Element enthalten. Dabei sind Siliziumverbindungen, insbesondere Siliziumoxid, Siliziumnitrid, Siliziumlegierungen, dotiertes Silizium etc. möglich.

Bei einem weiteren bevorzugten Ausführungsbeispiel der Erfindung kann die Verzögerungsschicht eine Isolatorschicht eines elektrischen Elements mit einer SOI (Silicon On Isolator)-Struktur sein. Bei einer solchen SOI-Struktur, ist die Isolatorschicht notwendigerweise in dem Element enthalten, so daß die Verzögerungsschicht nicht zusätzlich erzeugt werden muß.

Im folgenden wird die Erfindung anhand der Zeichnung näher erläutert.

Es zeigen:
Fig. 1 einen Ausschnitt durch den Querschnitt eines Halbleiterwafers, an dessen Vorderseite und Rückseite elektronische Elemente ausgebildet sind und
Fig. 2 eine Draufsicht auf den Halbleiterwafer der Fig. 1.

Im folgenden wird die Erfindung am Ausführungsbeispiel eines Halbleiterwafers mit elektronischen Elementen erläutert.

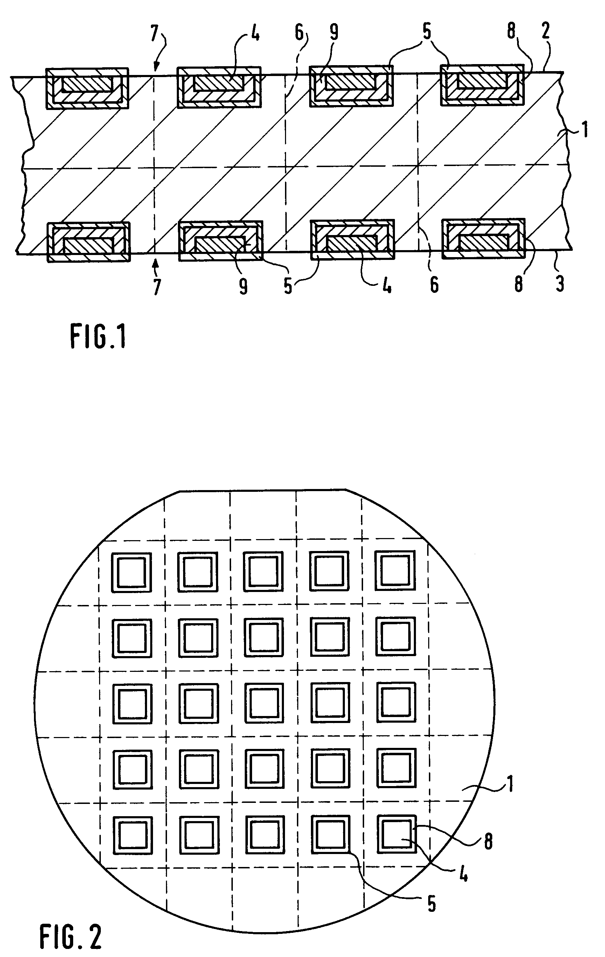

Fig. 1 zeigt einen Ausschnitt eines Halbleiterwafers 1. Der Halbleiterwafer 1 ist im Querschnitt dargestellt. Auf der Vorderseite 2 und der Rückseite 3 des Halbleiterwafers 1 sind elektronische Elemente 4 vorgesehen, von den auf der Vorderseite 2 und der Rückseite 3 jeweils vier Stück gezeigt sind. Die elektronischen Elemente 4 sind von einer Schutzschicht 5 überdeckt. Zwischen den elektronischen Elementen 4 sind in dem Halbleiterwafer 1 Trennbereiche 6 vorgesehen. Die Trennbereiche 6 müssen vorhanden sein, um die elektronischen Elemente 4 voneinander zu trennen bzw. aus dem Halbleiterwafer 1 herauszulösen. In der Schutzschicht 5 sind über den Trennbereichen 6 Öffnungen 7 ausgebildet. Ferner sind die elektronischen Elemente 4 innerhalb des Halbleierwafers 1 von einer Verzögerungsschicht 8 umgeben. Zwischen den elektronischen Elementen 4 und der Verzögerungsschicht 8 ist ein Zwischenbereich 9 vorhanden, der aus dem Material des Halbleiterwafers 1 besteht. Der Zwischenbereich 9 ist für die Erfindung nicht unbedingt erforderlich. Abhängig von dem Material der Verzögerungsschicht 8 und der gewünschten Endgröße der elektronischen Elemente 4 kann die Verzögerungsschicht 8 auch direkt an die elektronischen Elemente 4 angrenzen.

In Fig. 2 ist eine Draufsicht auf einen Halbleiterwafer 1 gezeigt, in dem die elektronischen Elemente 4 ausgebildet sind. Sie werden hier beispielsweise von der Vorderseite 2 des Halbleiterwafers 1 aus betrachtet. Die elektronischen Elemente 4 sind jeweils von der Verzögerungsschicht 8 umgeben. Die elektronischen Elemente 4 und die dazugehörige Verzögerungsschicht 8 sind jeweils von der Schutzschicht 5 überdeckt. In der Schutzschicht 5 erkennt man Öffnungen 7 zwischen den benachbarten elektronischen Elementen 4.

Gemäß dem erfindungsgemäßen Verfahren wird der Halbleiterwafer 1 einem Abtragvorgang unterzogen. Hierzu ist jedes Verfahren geeignet, bei dem das Material des Halbleiterwafers 1 im wesentlichen isotrop abgetragen wird. Unter im wesentlichen isotrop ist hier zu verstehen, daß der Abtragvorgang eine Komponente senkrecht zur Oberfläche des Halbleiterwafers 1 und Komponenten parallel zu der Oberfläche des Halbleiterwafers 1 hat. Das Material muß durch das Verfahren gleichzeitig in diesen Richtungen abgetragen werden. Ein bevorzugtes Verfahren ist hierbei ein Ätzverfahren, wobei Plasmaätzen den Vorteil hat, daß das Abtragen des Materials des Halbleiterwafers 1 besonders schnell erfolgt. Der Halbleiterwafer 1 wird dabei auf der Vorderseite 2 und auf der Rückseite 3 gleichzeitig dem Ätzverfahren unterzogen. Die Schutzschicht 5 ist dabei so gewählt, daß sie eine wesentlich kleinere Ätzrate als das Material des Halbleiterwafers 1 hat. Dann wird bei dem Ätzprozeß das Material des Halbleiterwafers 1 von den Öffnungen 7 der Schutzschicht 5 ausgehend geätzt.

In dem gezeigten Ausführungsbeispiel ist das Material der Verzögerungsschicht 8 so gewählt, daß sie eine kleinere Ätzrate als das Material des Halbleiterwafers 1 hat. In diesem Fall besteht die Verzögerungsschicht 8 aus demselben Grundmaterial wie der Halbleiterwafer 1 und enthält zusätzlich noch ein geeignet ausgewähltes anderes chemisches Element. Ist der Halbleiterwafer 1 ein Siliziumwafer, so besteht die Verzögerungsschicht 8 aus einer Siliziumverbindung, einer Siliziumlegierung oder dotiertem Silizium. Das zusätzliche in der Verzögerungsschicht 8 enthaltene chemische Element ist so gewählt, daß die Ätzrate der Verzögerungsschicht 8 kleiner ist als die Ätzrate des Materials des Siliziumwafers. Es kommt hierbei insbesondere Siliziumoxid oder Siliziumnitrid in Betracht. Bei dem Ätzvorgang wird nun das Material des Halbleiterwafers 1 in der Richtung senkrecht zur Oberfläche und in den Richtungen parallel zu der Oberfläche gleichzeitig weggeätzt. Da die Verzögerungsschicht 8 eine kleinere Ätzrate hat, bleibt die Verzögerungsschicht 8 oder zumindest ein Teil davon erhalten, welcher durch das Ätzratenverhältnis von der Verzögerungsschicht 8 und dem Material des Halbleiterwafers 1 bestimmt wird. Auf diese Weise werden die von der Verzögerungsschicht 8 umgebenen elektronischen Elemente 4 aus dem Halbleiterwafer 1 herausgelöst. Ist die Ätzrate der Verzögerungsschicht 8 genügend klein gewählt, so bestimmt die Verzögerungsschicht 8 die Form der verbleibenden, herausgelösten elektronischen Elemente 4.

Das Ätzratenverhältnis der Verzögerungsschicht 8 zu dem Halbleiterwafer 1 kann auch so gewählt sein, daß die Verzögerungsschicht 8 ganz weggeätzt wird und nur die elektronischen Elemente 4 und ein Teil des sie umgebenden Materials des Halbleiterwafers 1 aus dem jeweiligen Zwischenbereich 9 stehenbleibt.

Das Material der Schutzschicht 5 ist in der Regel so gewählt, daß die Schutzschicht 5 oder ein wesentlicher Teil von ihr bei dem Ätzverfahren stehenbleibt und die elektronischen Elemente 4 durch sie geschützt werden. Die Schutzschicht 5 kann aus Metall bestehen. Bei elektronischen Elementen kann sie gegebenenfalls bereits durch auf diese aufgebrachte Leiterbahnen vorgesehen sein.

Das erfindungsgemäße Verfahren kann dadurch variiert werden, daß andere Eigenschaften oder eine andere Anordnung der Verzögerungsschicht 8 gewählt werden. So kann die Verzögerungsschicht 8 beispielsweise direkt, ohne einen Zwischenbereich 9 die elektronischen Elemente umgeben. Auch kann die Verzögerungsschicht 8 aus einem Material mit einer größeren Ätzbarkeit als die des Materials des Halbleiterwafers 1 gewählt werden. Dann müssen die Öffnungen 7 der Schutzschicht 5 so vorgesehen werden, daß die Verzögerungsschicht 8 an den Oberflächen des Halbleiterwafers 1 freigelegt wird. Bei dem Ätzverfahren würde dann lediglich die Verzögerungsschicht 8 herausgelöst und somit die elektronischen Elemente 4 vereinzelt.

Es ist möglich, den Halbleiterwafer 1 nach Herauslösen der elektronischen Elemente 4 weiterzuverwenden, da ein erheblicher Teil des Halbleiterwafermaterials erhalten bleibt. Der Halbleiterwafer 1 müsste dazu auf der Vorderseite 2 und der Rückseite 3 so bearbeitet werden, daß wieder ebene Oberflächen entstehen. Dann können durch entsprechende Verfahrensschritte wieder elektronische Elemente 4 im Halbleiterwafer 1 erzeugt werden. Es ist bei diesem Verfahren auch möglich, auf der Vorderseite 2 und auf der Rückseite 3 des Halbleiterwafers 1 unterschiedliche elektronische Elemente zu erzeugen. Ebenfalls ist das Verfahren auch dann durchführbar, wenn die elektronischen Elemente 4 auf der Vorderseite 2 und der Rückseite 3 des Halbleiterwafers 1 einander nicht paarweise gegenüberliegen, sondern gegeneinander versetzt sind.

## Patentansprüche

1. Verfahren zum Vereinzeln von in einem Körper enthaltenen elektronischen Elementen (4), welche an einer Oberfläche des Körpers vorgesehen und mit einer Schutzschicht (5) überdeckt sind, dadurch gekennzeichnet, daß in der Schutzschicht (5) über Trennbereichen (6) zwischen benachbarten elektronischen Elementen (4) Öffnungen (7) vorgesehen sind, daß das Material des Körpers in den Trennbereichen (6), von den Öffnungen (7) ausgehend, abgetragen wird, und die elektronischen Elemente (4) in dem Körper zumindest während des Abtragvorgangs durch einen Bereich mit einer von dem Material des Körpers verschiedenen Abtrageigenschaft begrenzt sind.

2. Verfahren nach Anspruch 1, dadurch gekennzeichnet, daß die elektronischen Elemente (4) auf der Vorderseite (2) und auf der Rückseite (3) des Körpers vorgesehen sind.

3. Verfahren nach einem der vorangehenden Ansprüche, dadurch gekennzeichnet, daß das Abtragen des Materials des Körpers durch Ätzen, insbesondere durch Plasmaätzen, erfolgt.

4. Verfahren nach einem der vorangehenden Ansprüche, dadurch gekennzeichnet, daß das Abtragen des Materials des Körpers im wesentlichen isotrop erfolgt.

5. Verfahren nach einem der vorangehenden Ansprüche, dadurch gekennzeichnet, daß das Material der Schutzschicht (5) eine wesentlich kleinere Ätzrate als das Material des Körpers hat.

6. Verfahren nach einem der vorangehenden Ansprüche, dadurch gekennzeichnet, daß der die elektronischen Elemente (4) begrenzende Bereich durch eine elektrische Potentialdifferenz gebildet wird.

7. Verfahren nach einem der vorangehenden Ansprüche, dadurch gekennzeichnet, daß der die elektronischen Elemente begrenzende Bereich eine Verzögerungsschicht (8) ist, deren Ätzrate von der Ätzrate des Materials des Körpers verschieden ist.

8. Verfahren nach einem der vorangehenden Ansprüche, dadurch gekennzeichnet, daß der Körper ein Silizium-Wafer ist, und die Verzögerungsschicht (8) Silizium und wenigstens ein weiteres chemisches Element enthält.

9. Verfahren nach einem der vorangehenden Ansprüche, dadurch gekennzeichnet, daß die Verzögerungsschicht (5) eine Isolatorschicht eines elektronischen Elements (4) mit einer SOI-Struktur ist.
